# EUROPEAN PATENT APPLICATION

(11) **EP 2 863 441 A1**
(43) Date of publication of application: **22.04.2015**
(21) Application number: 13189532.8
(22) Date of filing: 21.10.2013
(51) Int. Cl.: H01L 31/0224

(54) **Method for producing a backside contact in a solar cell device and solar cell device**

(71) Applicant: APPLIED MATERIALS ITALIA S.R.L., 31048 San Biagio di Callalta (TV) (IT)
(72) Inventor: Cellere, Giorgio, 36040 Torri di Quartesolo (VI) (IT); Tonini, Diego, 31100 Treviso (IT)
(74) Representative: Zimmermann & Partner Patentanwälte mbB

(57) **Abstract**

According to an aspect, a method for producing a backside contact in a solar cell is provided. The method includes providing a wafer with a backside, a front side, and one or more through hole through the wafer; filling the through hole with a first paste from the backside; and depositing a second paste on the filling from the backside. According to another aspect, a solar cell device is provided. The solar cell device includes a wafer with a backside and a front side; and a backside contact. The back side contact includes one or more through hole through the wafer; a filling of the one or more through hole made of a first paste; and a backside tabbing positioned on the backside of the wafer on the filling with the tabbing made of a second paste. The silver content by weight of the first paste may be higher than the silver content by weight of the second paste.

## Description

### FIELD OF THE INVENTION

Embodiments of the present disclosure relate to a method for producing a contact in a solar cell device, in particular, for producing a frontside contact on the backside of a back contact solar cell device, in particular in a Metal Wrap Through solar cell device. Furthermore, embodiments of the present disclosure relate to a solar cell device including at least one contact, in particular, to a frontside contact positioned on the backside of the solar cell, in particular of a Metal Wrap Through solar cell device.

### DESCRIPTION OF THE RELATED ART

Solar cell devices are photovoltaic (PV) devices that convert sunlight into electrical power. A typical solar cell device, which might also be called only "solar cell" or "cell" herein, includes a substrate that may also be called wafer herein. The wafer is typically made of silicon. The wafer may be provided with one or more p-n or p-i-n junctions formed therein. Each p-n junction has a p-type region and an n-type region. When the p-n junction is exposed to sunlight, the sunlight is converted to electricity through the PV effect. A multitude of solar cells are typically assembled together to form a panel or, synonymously, a module. Panels are installed, for instance, on house roofs or the like.

Solar cells are commonly formed from silicon substrates, which can be monocrystalline or multi-crystalline silicon substrates. The silicon substrate may have a thin layer of n-type silicon on the front side with a p-type zone formed on the backside. Alternatively, the silicon substrate may have a thin layer of p-type silicon on the front side with a n-type zone formed on the backside (so-called "n-type wafer"). Additional layers such as anti-reflection layers on the front side, or reflection layers on the backside may furthermore be provided.

The present disclosure is particularly directed at back contact solar cells, i.e. solar cells with the contacting on the backside. One of the methods of producing back-contact solar cells includes Metal Wrap Through (MWT) technology, where not only the backside contacts are printed on the backside but also the contacts (in particular the busbars) for the regions of the front side are positioned on the back surface. The collection junctions or fingers, however, may still be positioned on the front side of the solar cell. The printing pattern on the front side may also be called "front side pattern" herein.

Thus, the current collected on the front side by the collection junctions or fingers is conducted to the backside via through holes which extend transversely through the wafer. The current is then collected through one or more busbars positioned on the backside surface of the solar cell. In this way, losses due to the zones darkened by the front metallization grid are reduced, since busbars are positioned on the non-illuminated side of the solar cell.

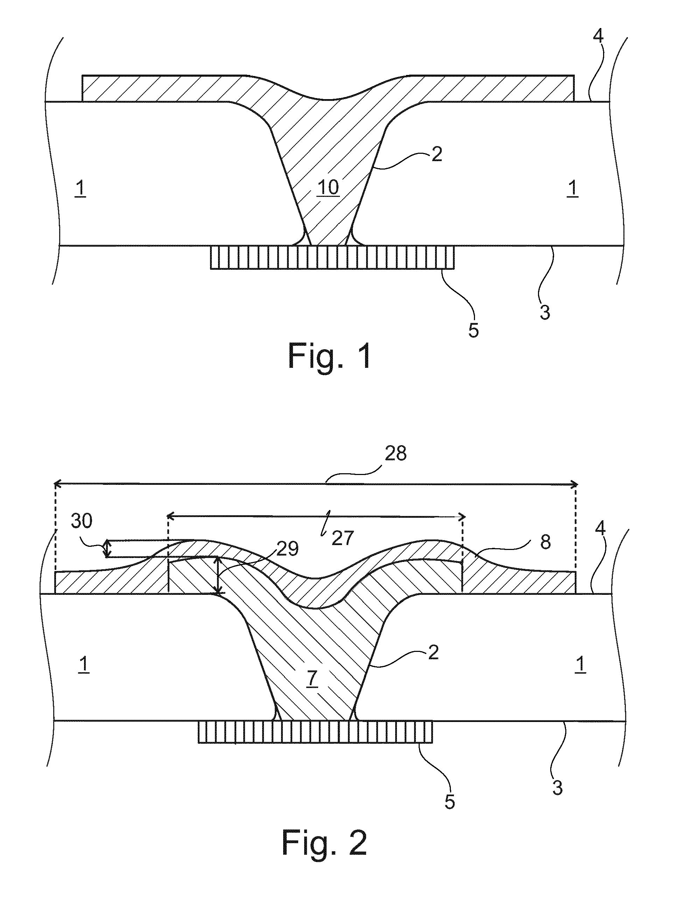

Fig. 1 shall illustrate a part of a solar cell including the wafer 1 with a through hole 2. The shown solar cell rests on its front side 3. The through hole 2 is positioned such that it leads to the electrically conductive finger 5 that is positioned on the front side 3 of the solar cell. In order to electrically contact the front side 3 of the solar cell with the backside 4, the through hole is filled with a conductive material forming the filling 10. Notably, the filling 10 is typically not only filling the through hole but exceeds the through hole's diameter thus additionally forming a tabbing.

The material costs for producing the contact for a back contact solar cells as described are high. Furthermore, the conductivity of the contacts as known can still be improved leading to an overall performance improvement of the solar cell.

### SUMMARY OF THE INVENTION

In view of the above, the present disclosure provides the following.

According to an aspect, a method for producing a backside contact in a solar cell is provided. The method includes providing a wafer with a backside, a front side, and one or more through hole through the wafer; filling the through hole with a first paste from the backside; and depositing a second paste on the filling from the backside.

According to another aspect, a solar cell device is provided. The solar cell device includes a wafer with a backside and a front side; and a backside contact. The back side contact includes one or more through hole through the wafer; a filling of the one or more through hole made of a first paste; and a backside tabbing positioned on the backside of the wafer on the filling with the tabbing made of a second paste.

According to particular embodiments, the silver content by weight of the first paste is higher than the silver content by weight of the second paste.

Further embodiments, aspects, details and advantages are furthermore evident from the dependent claims, the description, and the drawings.

### BRIEF DESCRIPTION OF THE DRAWINGS

So that the manner in which the above recited features of the present disclosure can be understood in detail, a more particular description of the disclosure, briefly summarized above, may be had by reference to embodiments. The accompanying drawings relate to embodiments of the disclosure and are described in the following:
Fig. 1 illustrates a schematic cross-sectional view of a part of a solar cell device according to known MWT technology;
Fig. 2 illustrates a schematic cross-sectional view of a part of a solar cell device according to embodiments of the present disclosure;
Fig. 3 illustrates a schematic cross-sectional view of a part of a solar cell device according to embodiments of the present disclosure;
Fig. 4 illustrates a schematic cross-sectional view of a part of a solar cell device according to embodiments of the present disclosure;
Fig. 5 illustrates a schematic cross-sectional view of a part of a solar cell device according to embodiments of the present disclosure;
Fig. 6 illustrates schematically a process for solar cell contact production according to known MWT technology;
Fig. 7 illustrates schematically a process for a solar cell contact production according to embodiments as described herein;
Fig. 8 illustrates a schematic top view of the backside of a wafer after producing fillings according to embodiments described herein;
Fig. 9 illustrates a schematic top view of the backside of a wafer after additionally producing tabbings according to embodiments described herein;
Fig. 10 illustrates a schematic top view of the backside of a wafer after additionally producing bog pads according to embodiments described herein;
Fig. 11 illustrates a schematic top view of the backside of a wafer after additionally producing bog pads and insulation layers according to embodiments described herein;
Fig. 12 illustrates a schematic cross-sectional view of a part of a solar cell device according to embodiments of the present disclosure;
Fig. 13 illustrates a schematic cross-sectional view of of a part of a solar cell device according to embodiments of the present disclosure; and
Fig. 14 illustrates the top view of the part of the embodiment illustrated in Fig. 13.

### DETAILED DESCRIPTION OF EMBODIMENTS

Reference will now be made in detail to the various embodiments of the invention, one or more examples of which are illustrated in the figures. Within the following description of the drawings, the same reference numbers refer to same components. In the present disclosure, only the differences with respect to individual embodiments are described. Each example is provided by way of explanation of the invention and is not meant as a limitation of the invention. Further, features illustrated or described as part of one embodiment can be used on or in conjunction with other embodiments to yield yet a further embodiment. It is intended that the description includes such modifications and variations.

The present disclosure proposes filling the through holes of a wafer for producing a contact in a MTW technology as follows. First, a first paste is filled in the through holes from the backside of the wafer. Thereby, a filling of the through hole is generated. Filling as understood herein may be done by filling techniques such as printing, evaporation, plating, chemical vapour deposition (CVD), physical vapour deposition (PVD), sputtering, and so on. For the sake of illustration only but not limiting in any sense, the following is explained based on printing as the filling technique. Other filling techniques could also be used. Furthermore, paste as understood herein typically refers to a conductive paste adapted for deposition to form an electrical contact.

According to typical embodiments, the filling does not only fill the through hole but exceeds the through hole. The filling may thus exceed the through hole above the backside surface of the wafer, which shall be called "in the vertical direction" herein (i.e., the direction perpendicular to the wafer surface). The filling may additionally or alternatively exceed the through hole in the horizontal direction (which shall be understood as the direction parallel to the backside of the wafer herein).

Subsequently, a second paste is deposited on the filling. The deposition of the second paste forms a so-called "tabbing" on the wafer. Again, deposition may be done by deposition techniques such as printing, evaporation, plating, chemical vapour deposition (CVD), physical vapour deposition (PVD), sputtering, and so on. For the sake of illustration only, but not limiting in any sense, the following is explained based on printing as the deposition technique. Other deposition techniques could also be used.

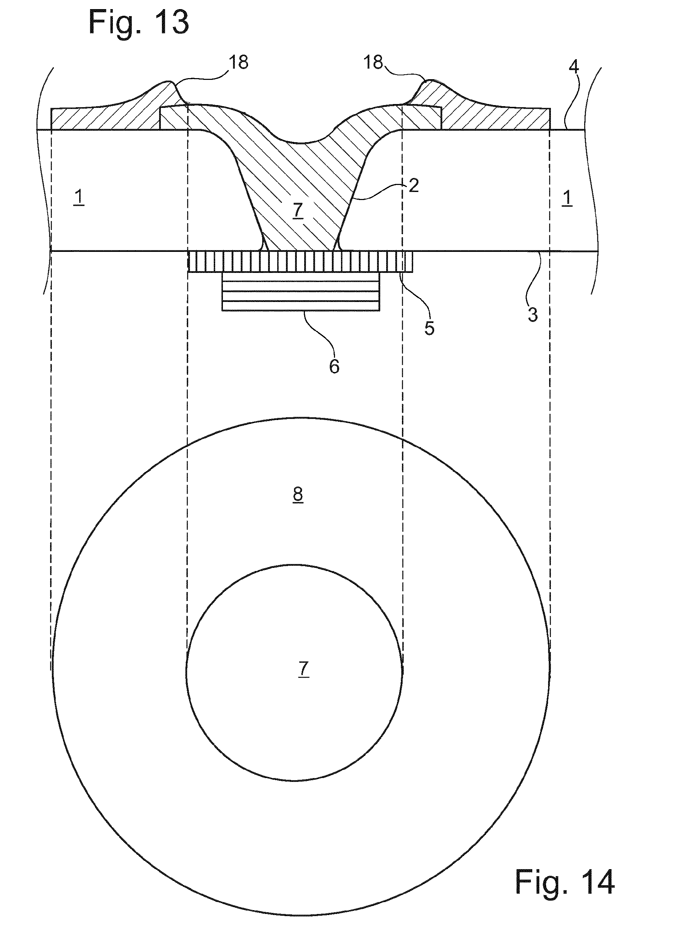

According to embodiments, the tabbing completely covers the filling. According to other embodiments explained in more detail in particular with reference to Figs. 13 and 14, the tabbing may be provided in a ring-shape with part of the ring covering the filling. In any event, the tabbing is deposited such that it contacts the filling.

According to typical embodiments, the first paste contains a higher level of silver than the silver content of the second paste.

In particular, the silver content of the first paste may be 75% by weight or more. According to some embodiments, the silver content of the first paste is 85% by weight or more.

In other embodiments, some of the silver in the first paste may be replaced with one or more another transition metals such as nickel. In other words, the silver content of the first paste may be, for instance, 65% by weight or more, and 10% by weight of the paste may be one or more of other transition metals, such as nickel. Even more, the second paste may be a mixture of at least 75% by weight of silver and at least 10% of other transition metals. Typically, the other transition metal in the first paste apart from silver is not a noble metal.

The second paste may include a reduced silver content as compared to the silver content of the first paste. The silver content of the second paste is typically 65% by weight at most or even less than 60% by weight. According to embodiments, the silver content of the second paste may be less than 30%. In some embodiments, the silver content of the second paste is below 10% by weight. Also the second paste may include one or more other transition metals.

The second paste is typically deposited atop of the filling. The layer deposited with the second paste shall be called tabbing herein. The tabbing as understood herein typically exceeds the surface area of the filling on the wafer surface. In typical embodiments, the tabbing is configured to be connected with the electrical contacts provided in a solar cell module.

The tabbing may also form part of a bus bar. A bus bar as understood herein collects the current from a multitude of fingers and provides the contact to external connection, such as a solar cell module connection. Hence, the bus bar, which the tabbing may be part of as described herein, allows the electrical current to flow from the front side of the solar cell to, for instance, the connection of the solar cell to the solar cell module contacts.

Embodiments of the present disclosure relate to the backside contact formation. In other words, the deposition of the filling and the tabbing as explained herein is particularly done from the backside. This is beneficial over front side printing because the process from the backside as described leads to less coverage of the front side with light blocking material, thus resulting in an increase of the front side surface that can contribute to the generation of electricity.

Fig. 2 shall exemplarily illustrate a part of a solar cell device according to embodiments described herein. According to the figure, the wafer 1 includes the through hole 2. According to embodiments, each wafer is provided with at least 3x3 through holes. The number of through-holes may be no more than 5x5. According to embodiments, the through holes are arranged in an array. For the sake of understandability, the contact deposition will be explained based on one through hole only in the following.

The through holes may be provided in the wafer already when the method according to the subject-matter described herein starts. Alternatively, a drilling step, such as by use of a laser, may be included in order to produce the through holes 2 in the wafer 1.

The through hole 2 as illustrated in Fig. 2 is filled with a conductive material to produce a contact path between the front side 3 of the wafer, namely, a front side contact 5 on the front side 3, and the backside 4 of the wafer. The front side contact is illustratively shown as produced in a single-printing step and may be called "finger" herein. As explained before, according to aspects of the present disclosure, the finger 5 on the solar cell's front side 3 shall be connected to the bus bars on the backside 4. The front side contact may be deposited before the backside contact formation or afterwards. Not limited to any embodiment, the front side contact 5 may also be provided in a double-printing process.

In order to fill the through hole 2, a first paste is used resulting in the filling 7 of the through hole 2. The first paste is typically not only filled into the through hole but may additionally exceed the through hole. The portion deposited with the first paste that exceeds the through hole on the back side surface may be referred to as "filling excess" herein. Notably, the term "filing" can be understood as including the first paste within the through hole and, if any, the filling excess.

As explained in further detail herein below, the front side contact such as finger 5 is typically not yet printed at this stage. Rather, the wafer may not yet include electrically conductive coatings on the front side.

The filling 7 is typically produced by applying a suction from the front side, which the wafer rests on, while applying the first paste to the backside. Thereby, the first paste is drawn through the through hole, thus forming the filling. The first paste thus should have both a suitable viscosity and a high conductivity. According to embodiments of the present subject-matter, the amount of a transition metal, in particular silver, contained in the first paste is thus 75% by weight or more. According to some embodiments, the amount of a transition material, in particular silver, contained in the first paste is thus even more than 85% by weight or 90% by weight. Generally, and not limited to any embodiment, the rest of the paste can be solvents, binders, glass frits, or the like. It is also possible that the rest contains aluminum, however, according to other embodiments, the first paste does not include aluminum.

According to still other embodiments, the amount of silver contained in the first paste is 65% by weight or more, and at least 5% by weight or even at least 10% by weight are another transition metal, such as nickel. The other transition metal is typically not a noble metal.

According to embodiments of the present disclosure, a second paste is applied onto the filling thus forming the tabbing 8. The tabbing typically covers the filling 7 completely. In addition, according to embodiments, the tabbing exceeds the filling by size in the horizontal direction. This is also exemplarily illustrated in Fig. 2 where the tabbing has a circumference that is essentially larger than the circumference of the filling.

In particular, the surface of the tabbing may be at least twice as large as the surface of the filling on the backside. For instance, the diameter of the filling on the filling's upper side, i.e. on the backside of the wafer, as illustrated by arrow 27 in Fig. 2, may be 300 µm or more. Additionally or alternatively, the diameter of the filling excess on the filling's 7 upper side, as illustrated by arrow 27 in Fig. 2, may be 800 µm or less. The diameter of the through hole may be at least 50 µm and, additionally or alternatively, smaller than 250 µm. In embodiments, the diameter of the filling excess is at least 100 µm larger than the diameter of the through hole. The term "diameter" of an element herein refers to the largest distance between all possible points of the element. In the event of a circular shape, the term diameter thus corresponds to twice the radius of the circular. According to aspects, the filling's upper side may be circular including, however, usual deviations from the perfect circular shape that happen in practice.

Furthermore, for instance, the diameter of the tabbing, as illustrated by arrow 28 in Fig. 2, may be 2.5 mm or more. Additionally or alternatively, the diameter of the tabbing 8, as illustrated by arrow 28 in Fig. 2, may be less than 8 mm or even less than 5 mm. According to aspects, the tabbing may be circular including, however, usual deviations from the perfect circular shape that happen in practice. According to embodiments, the tabbing is provided with a hole, such as in the case of a ring shape.

Accordingly, it is possible that the diameter of the tabbing is between 5 and 15 times larger than the diameter of the filling excess. Evidently, the amount of material used for the tabbing is essentially more than material used for the filling in these embodiments.

Furthermore, according to aspects of the present disclosure, the thickness of the filling excess on the backside 7 of the wafer 1 is more than 1.3 times or even more than 1.5 times the thickness of the tabbing 8. The "thickness" of the filling excess shall refer to the part of the filling that exceeds the backside level and shall understood as the maximal direct distance between the surface of the filling to the backside level of the wafer, and is exemplarily illustrated in Fig. 2 and denoted with reference number 29 therein. The "thickness" of the tabbing shall be understood as the maximal direct distance between the surface of the tabbing to the backside level of the wafer minus the thickness of the filling excess. This is exemplarily illustrated in Fig. 2 and denoted with reference number 30.

According to the present disclosure, the amount of silver used in the second paste is 65% silver at most. The rest of the paste may include, for instance, aluminum. The paste may further include other elements such as solvents, binders, glass frits, or the like.

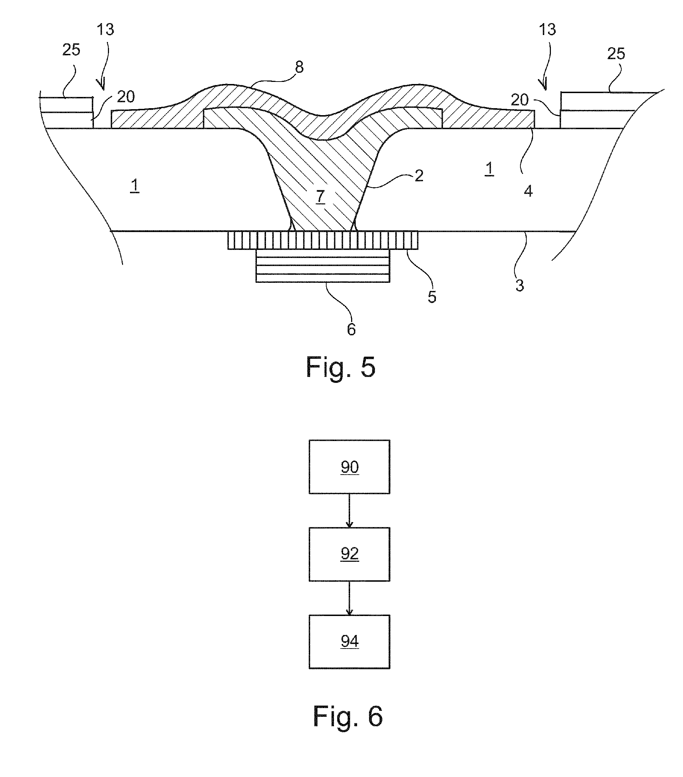

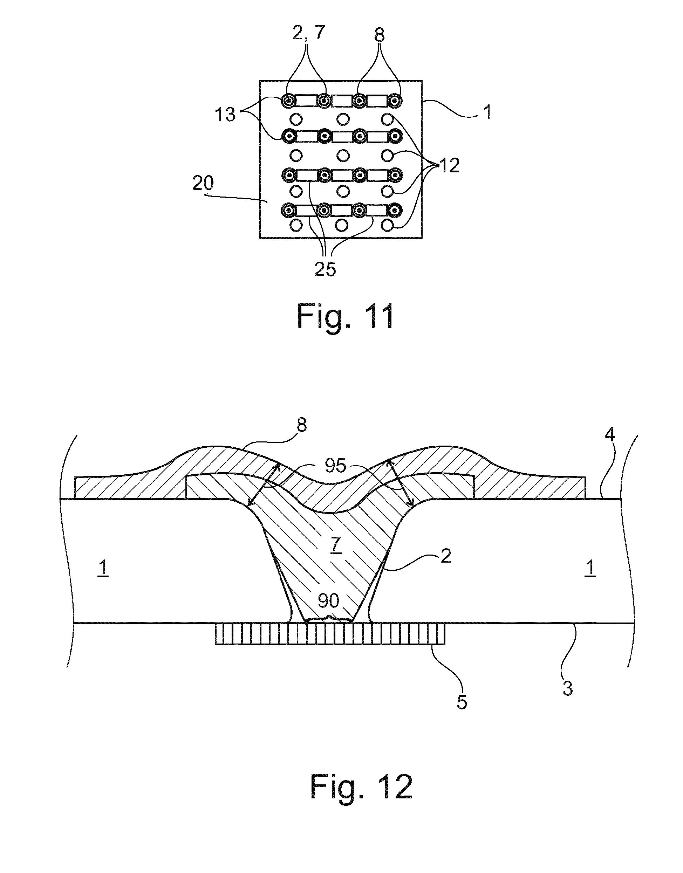

According to embodiments not limited to any figure described herein, at least nine tabbings, in particular at least 16 tabbings are provided per solar cell device. The multitude of tabbings 8 on the solar cell device provide individual contacts to the front side. To collect the individual currents from the multitude of tabbings, a connection between all tabbings can be provided allowing conducting the generated electricity. This will be explained in more detail with respect to Figs. 5 and 12.

According to embodiments, as described, a different paste is used for the deposition of the filling than for the deposition of the tabbing. By using different pastes, in particular by using a paste with less silver for the tabbing, the overall material costs can be essentially reduced with, at the same time, still providing sufficient contact area of the tabbing 8 and a high quality of the filling 7. The drawback of an additional deposition step is thereby accepted as being outweighed by the cost reduction in the used paste, and the further benefits of the two layer set-up.

Furthermore, the requirements for viscosity differ essentially between the deposition of the filling and the deposition of the tabbing. For instance, the generation of the filling may require a higher viscosity than the generation of the tabbing.

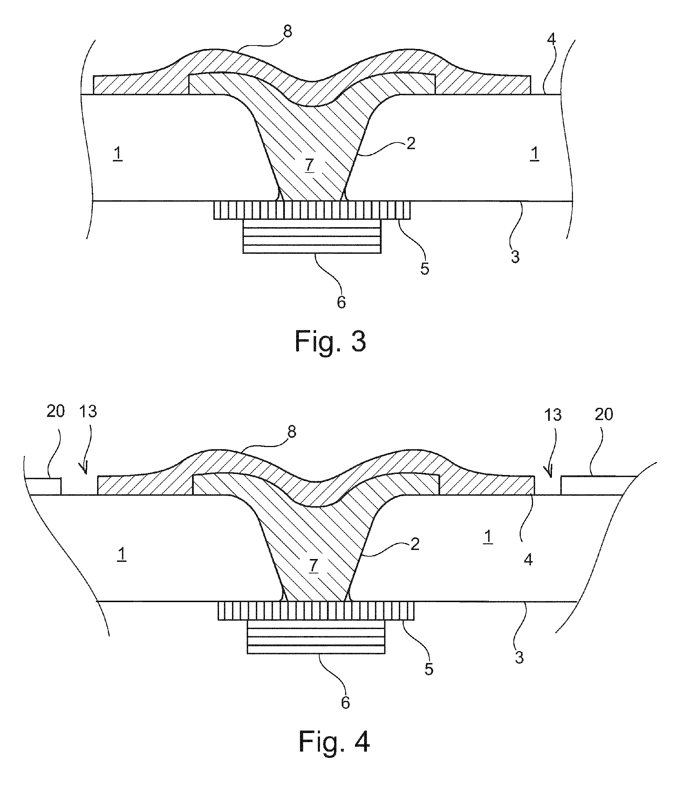

Fig. 3 illustrates a further embodiment of a part of a solar cell device according to embodiments described herein. The difference to the illustration of Fig. 2 is the double-printed front contact. The front contact in embodiments as illustrated in Fig. 3 includes the conductive layer 5 and an additional conductive layer 6 positioned atop of layer 5. Layers 5 and 6 thus form the so-called finger positioned on the front side 3 of the wafer. The combination of a double-printed front contact with the use of two different pastes for the filling and its tabbing as described herein allows for a high performance of the solar cell at beneficial production costs.

Fig. 4 illustrates embodiments of a part of a solar cell device according to embodiments described herein. Additionally to the elements described already with respect to the illustrations of Figs. 2 and 3, the embodiment of Fig. 4 includes the back layer 20. The back layer may include aluminum. Typically, the back layer includes 60% aluminum or more. The back layer may additionally include solvents, binders, vitrifying material etc.

Typically, the back layer covers most of the backside of the solar cell device. The back layer is supposed to reflect the incoming radiation that was not absorbed by the doped regions of the solar cell device. The back layer is typically in electrical contact with the backside of the solar cell device. The back layer is typically electrically isolated from the front side contacts. Hence, as illustrated in Fig. 4, the back layer 20 is electrically isolated from the tabbing 8 and the filling 7. An electrical connection would typically result in a short circuit. Accordingly, according to embodiments also illustrated in the embodiment of Fig. 4, the tabbing 8 may be surrounded by a gap 13 (with air acting as isolator) that isolates the front side potential of the tabbing from the backside potential present at the back layer.

The back layer is typically produced in a step separate from the printing step for producing the tabbing 8. In this case the back layer 20 is typically made with a paste different from the tabbing 8. According to other embodiments, the back layer may be printed in the same printing step as the tabbing so that the same paste may be used.

The gap 13 provided around the tabbing may be filled with an insulator so as to isolate the backside potential of the cell from the front side potential. Notably, the provision of the back layer and its composition as discussed is not limited to the embodiment of Fig. 4 but can be applied to any embodiment described herein, such as the embodiment illustrated with respect to Fig. 2.

Fig. 5 illustrates a further embodiment of a part of a solar cell device according to embodiments described herein. Additionally to the elements described already with respect to the illustrations of Figs. 2-4, the embodiment of Fig. 5 additionally includes the insulation layer 25 positioned atop of the back layer 20. The insulation layer may cover the complete back layer of the solar cell device. Alternatively, the insulation layer may cover only part of the back layer 20. The insulation layer 25 as illustrated in Fig. 5 provides an insulation from the backside potential of the solar cell device. To collect the individual currents from the multitude of tabbings, a connection between some or all tabbings may be provided above the isolation thus allowing to conduct the generated electricity. This connection may be an external (i.e., not forming part of the solar cell device) connection line, or alternatively, a layer (not shown) deposited atop of the insulation layer and the tabbings.

Figure 6 describes the process for MWT cell production as known to the inventors. In block 90, the through hole 2 is filled by printing a paste. Thereby, the filling 10 (Fig. 1) is produced that additionally serves as a tabbing in the art. In block 92, the back layer is printed, such as by printing aluminum. The wafer is then flipped to rest on the backside. In block 94, front side printing is undertaken.

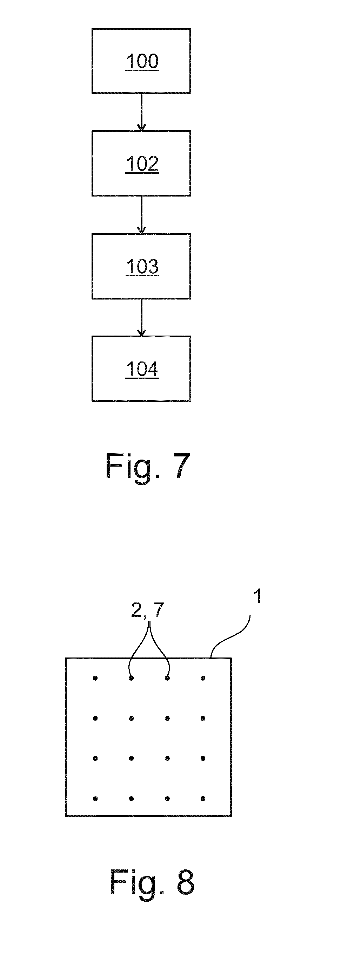

Figure 7 describes the process according to embodiments of the present disclosure. In block 100, the through hole 2 is filled as described herein, e.g., by printing, such as by printing the first paste that contains 75% or more by weight of silver. The filling does typically not include a tabbing at this stage.

Afterwards, in block 102, another printing is performed using the second paste that includes less silver by weight, for instance, 60% by weight of silver or less. Thereby, the tabbing is printed on top of the filling. According to embodiments, the tabbing completely covers the filling. In particular, according to embodiments, the tabbing exceeds the filling, typically in the horizontal and/or vertical direction.

In block 103, the back layer may be printed, such as by printing aluminum. The wafer may then be flipped. In block 104, front side printing is undertaken, such as by single-printing or double-printing of the fingers.

Notably, at least one of depositing the tabbing and depositing the filling as described herein, preferably both, is undertaken by printing.

Whereas Figs. 1-5, 12 and 13 show cross-sectional views of a wafer, Figs. 8-11 show top views from the backside of the wafer during the printing process according to embodiments described herein.

In the illustrative embodiments of Fig. 8, the wafer is provided with through holes 2. For instance, the through holes 2 may be drilled into the wafer by a laser beam. As shown, the through-holes may be provided in an equally distanced pattern. Typical numbers of through-holes are, 3x3, 4x4 (as illustrated in Fig. 8), or 5x5. According to aspects of the present disclosure, the through holes are filled with the first paste thus forming the fillings 7.

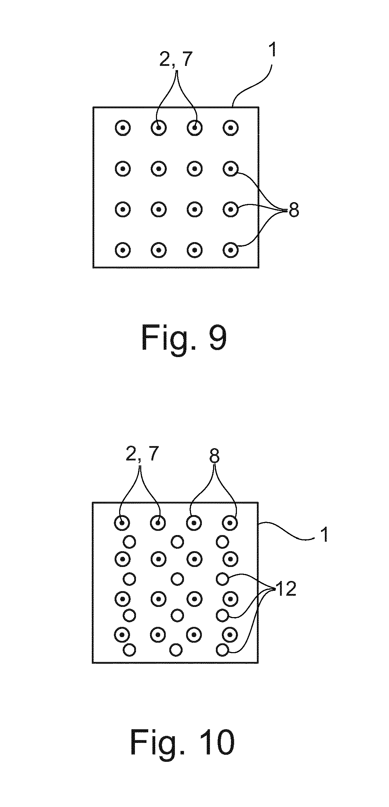

After that, as illustrated in Fig. 9, the tabbing 8 is printed on top of the fillings 7. As shown, according to embodiments combinable with all other embodiments described herein, the tabbings may be centered by the fillings. In any event, the tabbings are typically printed so as to be in direct contact with the filling.

In the embodiments illustrated with respect to Fig. 10, additionally to the tabbings 8, backside contact pads 12 for module connection of the backside of the solar cell are deposited, such as printed. A backside contact pad may have a diameter of between 2 mm and 4 mm, such as 3 mm. It is possible that the backside contact pad is printed in the same printing process as the tab printing. The same paste as used for the tabbings, i.e. the second paste, may be used for the print of the backside contact pads, in particular, the paste used for the backside contact pads 12 may contain less than 65% by weight of silver, optionally 35% by weight of silver or even less.

As explained previously with particular reference to Fig. 7, the back layer may be printed thereafter, which is typically done by printing a thin layer of aluminum. Fig. 11 illustrates embodiments including the back layer 20. The back layer 20 typically covers the wafer completely except the tabbings 8 and the gaps 13 surrounding the tabbings 8. The gaps 13 may be filled with an insulation layer. In particular, the back layer 20 may cover the backside contact pads 12 completely. Alternatively, the back layer 20 may cover the backside contact pads at least to such an extent that an electrical connection between backside contact pad 12 and the back layer 20 is constituted.

The embodiments exemplarily described in Fig. 11, additionally to the back layer 20, include the insulation layer 25. As illustrated, the insulation layer is typically not deposited over the whole wafer. Typically, the insulation layer 25 is provided between at least two neighboring tabbings 8. The insulation layer allows easy contacting of the tabbings 8 by, for instance, providing an electrical connection atop of the insulation layer 25, the tabbings 8 and the gaps 13.

After conducting the deposition as described so far, the wafer may then be flipped, e.g. by use of a flipper, in order to produce the front side pattern, such as the finger 5, in a single print process, as illustrated with respect to Fig. 2, or the front side finger 5, 6 in a double print process, as illustrated with respect to Figures 3-5.

Partly summarizing previous embodiments, the present disclosure particularly includes one or more of the following. Depositing one or more backside contact pads on the backside, such as by printing; depositing a back layer on the backside, such as by printing; depositing one or more bus bar on the backside, such as by printing; depositing an insulation layer on the backside; flipping the substrate; single-printing a finger on the front side; and double-printing a finger on the front side.

The present disclosure allows producing a contact for a back contact solar cell at reduced costs. In particular, the frontside contact, produced with the MWT technology, as provided by the present disclosure consumes less silver. In addition, the conductivity of the provided contact, consisting of the filling and the tabbing as previously explained, may be increased at the same time. This shall be illustrated with reference to the drawing depicted in Fig. 12 which represents a cross-sectional view of a part of a solar cell according to embodiments described herein.

The deposition process as disclosed herein provides a contact between the front side pattern, such as finger 5, and the backside busbar. In order to have a high performance of the solar cell, the resistivity of particularly this contact shall be as small as possible.

Whereas the paste material plays an essential role for the resistivity, the cross-sectional size of the electrical paths, through which the current flows, plays also an essential role for the resistivity. However, there is a trade-off between providing sufficiently wide paths for the current to flow and, at the other hand, avoiding extensive use of raw material, in particular of expensive raw material such as silver.

One of the constrictions the current has to overcome on its way between the front side and backside of the cell is the contact area between the filling, such as filling 7 in the embodiments illustrated herein, and the frontside pattern, such as finger 5. The contact area therebetween, which is exemplarily shown in Fig. 12 and denoted with reference number 90, is an essential factor that, inter alia, determines the resistivity of the contact.

By the application of the present disclosure, it is possible to use a different paste for the production of the filling than for the production of the tabbing. This allows optimizing the first paste, in particular with respect to the viscosity, to maximize the contact area 90. In particular, according to some embodiments, the first paste used for the filling 7 has an silver content of 75% by weight or more, in some embodiment of 90% by weight and more, even if silver is expensive. However, the use of such a paste is one possibility that the contact area 90 as illustrated in Fig. 12 is optimized, in other words, it is one possibility that this paste allows an optimized filling of the through hole in particular at the contact side to the finger of the front side of the solar cell.

As discussed, in embodiments of the present disclosure, a mixture of at least 65% by weight of silver and at least 5% by weight, at least 10% by weight or even at least 15% by weight of another transition material, such as nickel, may be used.

Another constriction of the electrical path is typically close to the edges of the through hole on the backside of the wafer. The size of the cross-section of the path for the current contributes to the resistivity of the contact. The path typically has a cross-section that has the least area. This is schematically shown in Fig. 12 and denoted with reference number 95. According to embodiments described herein, the path has a cross-section of between 5 µm and 50 µm.

According to the present disclosure, a tabbing made of a second paste is deposited on the filling. The second paste may be chosen independent from the first paste. In embodiments, the silver content of the second paste is smaller than the silver content of the second paste.. In particular, it may be optimized for the requirement to provide sufficient electrical conductivity of the contact at acceptable costs. Generally, and not limited to any embodiment, the silver content of the second paste is at least 15% by weight or at least 25% by weight or even at least 35% by weight smaller than the silver content of the first paste

Accordingly, in embodiments of the present disclosure, the second paste used for the tabbing contains no more than 65% by weight of silver, in some embodiments less than 60% by weight or even 35% by weight and less. Using a paste with a reduced amount of silver is cheaper than a paste with a high amount of silver. Using the paste as discussed allows printing the second paste (i.e., the paste of the tabbing) in a sufficient amount to reduce the resistivity of the tabbing, in particular at the positions of the cross-section 95 of the contact.

According to embodiments of the present disclosure, the filling of the through-hole on the backside of the wafer exceeds the backside surface level of the wafer. The backside surface level of the wafer shall refer to the backside plane, independent of whether there is a through hole in the backside at specific positions. The backside surface level may also be shortened to "backside surface" herein.

In absolute terms, the filling excess typically has a thickness (i.e., in the vertical direction) of at least 15 microns. The extension of the filling in the horizontal direction may be at least 10 microns or even at least 20 microns exceeding the diameter of the through hole.

In relative terms, the excess thickness of the filling excess may be larger than the thickness of the tabbing on the filling. In particular, the excess thickness of the filling excess may be at least 1.3 times or even at least 1.5 times the thickness of the tabbing on the filling.

Providing this relationship of the filling excess' thickness as compared to the thickness of the tabbing above the filling typically results in sufficient conductive material at the corners of the through hole on the back side. In other words, the cross-section 95 may thus be designed sufficiently large with, at the same time, no overall material waste of the second paste. Notably, the cross-section 95 around the corners of the through hole may be relevant for the conductivity. However, further away from the center of the filling on the backside, the current distributes over a larger area in the tabbing and thus, there is no need for a comparable thickness in the outer regions of the tabbing. In typical embodiments, the deposition thickness of the tabbing is essentially uniform with essentially including deviations of +/-15% that happen in practical applications.

According to embodiments described herein, the second paste is deposited in the shape of a ring. This may also be called donut-like shape herein. The cross-section of such a shape is exemplarily illustrated in the embodiment of Fig. 13 and Fig. 14.

Fig. 13 shows a cross-section of the deposition. Apart from the deposition shape of the second paste, the deposition process and the wafer may be provided with the elements and features discussed herein previously with respect to other embodiments discussed.

The second paste may deposited in a ring-shaped tabbing 18. In particular, in this case no deposition with the second paste is provided above the center of the deposition with the first past. Typically, the first paste layer is thus not covered in the center region of the layer deposited with the first paste, i.e., the filling 7, in particular in the region above the through hole 2. A typical diameter for the inner radius of the ring-shaped tabbing 18 may be similar to the diameter of the through hole. "Similar" in this context shall be understood as identical +/- 20% deviation. According to embodiments, a typical diameter of the inner ring radius may be in the range of between 80 µm and 300 µm.

Fig. 14 shows the top view on the backside of the part of the solar cell illustrated in Fig. 13. The figure shall highlight the ring shape of the deposition of the tabbing.

While the foregoing is directed to embodiments of the invention, other and further embodiments of the invention may be devised without departing from the basic scope thereof, and the scope thereof is determined by the claims that follow.

## Claims

1. A method for producing a backside contact in a solar cell, comprising:
a. providing a wafer including a backside, a front side, and at least one through hole through the wafer;
b. filling the through hole with a first paste from the backside; and
c. depositing a second paste on the filling from the backside.

2. The method of claim 1, wherein the first paste includes a higher content of a transition metal than the second paste, wherein the first paste preferably includes
at least 75% by weight of a transition metal with the transition metal preferably being silver; or
at least 75% by weight of a mixture of silver and a further transition metal with the content of the further transition metal preferably not exceeding 15% by weight of the first paste.

3. The method of claim 1 or 2, wherein the second paste includes at most 65% by weight, preferably at most 60% by weight, even more preferably at most 35% by weight of a transition metal, such as silver.

4. The method according to any of the preceding claims, wherein the first paste includes
at least 85% by weight of a transition metal, wherein the transition metal is preferably silver; or
at least 85% by weight of a mixture of silver and a further transition metal with the content of the further transition metal preferably not exceeding 15% by weight of the first paste.

5. The method according to any of the preceding claims, wherein filling the through-hole further includes depositing the first paste on the backside of the wafer in such a way that it forms a filling excess on the backside surface of the wafer with an excess thickness of preferably at least 10 microns.

6. The method according to claim 5, wherein the second paste is deposited to form a tabbing, wherein the excess thickness of the filling excess is larger than the thickness of the tabbing, wherein the excess thickness of the filling excess is preferably at least 1.3 times, preferably 1.5 times the thickness of the tabbing.

7. The method according to any of the preceding claims, wherein the second paste is deposited to form a tabbing with the tabbing preferably being ring-shaped.

8. The method according to any of the preceding claims, further including one or more of the following:
• depositing one or more backside contact pads on the backside;
• depositing a back layer on the backside;
• depositing one or more bus bar on the backside;
• depositing an insulation layer on the backside;
• flipping the substrate;
• single-printing a front side pattern on the front side; and
• double-printing a front side pattern on the front side.

9. The method according to claim 8, wherein depositing one or more back layers on the backside is undertaken in the same deposition step as depositing the second paste.

10. A solar cell device, comprising:
a wafer including a backside and a front side;
a backside contact including:
at least one through hole through the wafer;
a filling of the at least one through hole made of a first paste; and
a backside tabbing positioned on the backside of the wafer on the filling with the tabbing made of a second paste.

11. The solar cell of claim 10, wherein the first paste includes a higher content of silver than the second paste, wherein the first paste preferably includes
at least 75% by weight of a transition metal, wherein the transition metal is preferably silver; or
at least 75% by weight of a mixture of silver and a further transition metal with the content of the further transition metal preferably not exceeding 15% by weight of the first paste.

12. The solar cell of claim 10 or 11, wherein the second paste includes at most 65% by weight, preferably at most 60% by weight, even more preferably at most 35% by weight of a transition metal such as silver.

13. The solar cell according to any of claims 10-12, wherein the first paste includes
at least 85% by weight of a transition metal, wherein the transition metal is preferably silver; or
at least 85% by weight of a mixture of silver and a further transition metal with the content of the further transition metal preferably not exceeding 15% by weight of the first paste.

14. The solar cell according to any of claims 10-13, wherein the tabbing is ring-shaped.

15. The solar cell according to any of claims 10-14, wherein the filling on the backside of the wafer exceeds the backside surface level of the wafer thereby forming a filling excess, wherein the filling excess preferably has an excess thickness of at least 15 microns.

16. The solar cell according to any of claims 15, wherein the second paste is deposited to form a tabbing, wherein the excess thickness of the filling excess is larger than the thickness of the tabbing, wherein the excess thickness of the filling excess is preferably at least 1.3 times, even more preferably at least 1.5 times the thickness of the tabbing.
